# EUROPEAN PATENT SPECIFICATION

(11) **EP 4 300 106 B1**
(45) Date of publication and mention of the grant of the patent: **04.11.2026**
(21) Application number: 22759639.2
(22) Date of filing: 22.02.2022
(51) Int. Cl.: G01R 19/165, G01R 31/00, H02J 7/00, H02H 3/087, H02H 7/18, H02J 7/62, H02J 7/60

(54) **BATTERY PACK FAILURE DIAGNOSTIC METHOD AND BATTERY PACK**
VERFAHREN ZUR DIAGNOSE VON BATTERIEPACKFEHLERN UND BATTERIEPACK
PROCÉDÉ DE DIAGNOSTIC DE PANNE DE BLOC-BATTERIE ET BLOC-BATTERIE

(30) Priority: 25.02.2021 JP 2021029199
(43) Date of publication of application: 03.01.2024
(73) Proprietor: Panasonic Energy Co., Ltd., Moriguchi-shi, Osaka, 570-8511 (JP)
(72) Inventor: SUYAMA Atsushi, Kadoma-shi, Osaka 571-0057 (JP); MAEGAWA Kazuya, Kadoma-shi, Osaka 571-0057 (JP); ARAI Yuji, Kadoma-shi, Osaka 571-0057 (JP)
(74) Representative: Novagraaf International SA
(86) International application number: PCT/JP2022/007204
(87) International publication number: WO 2022/181603

(56) References cited:
- EP-A2- 4 212 897
- WO-A1-2020/179479
- JP-A- 2000 206 215
- JP-A- 2002 325 363
- JP-A- 2007 033 108
- JP-A- 2020 051 863
- JP-A- 2021 018 138
- JP-A- 2021 501 325
- JP-A- H11 344 545
- US-A1- 2002 145 406
- US-B1- 6 239 581

## Description

### TECHNICAL FIELD

The present invention relates to a method of diagnosing a failure of a battery pack including an overcurrent detection circuit, and to a battery pack including the overcurrent detection circuit.

### BACKGROUND ART

A switching element, such as a field-effect transistor (FET), is connected to an output side of a battery pack to enhance the safety of the battery pack. The battery pack includes a switching element which cuts off a current in an abnormality. When overcurrent is detected, the switching element is turned off to cut off the overcurrent. In the battery pack, a circuit which detects overcurrent turns off the switching element to cut off the current. When overcurrent occurs, the battery pack reliably cuts off the current, thereby preventing the adverse effects caused by the overcurrent. Methods have been developed to prevent the adverse effects of the overcurrent. For example, PTL 1 discloses a method of detecting that a switching element which cuts off overcurrent operates normally. In the method disclosed in PTL 1, a failure is determined without turning off the switching element. However, the method fails to diagnose a failure of an overcurrent detection circuit which controls the turning on and off of the switching element, and hardly maintains the battery pack in a safe state.

### Citation List

### Patent Literature

PTL1: Japanese Patent Laid-Open Publication No. 2016-118571

Further art is disclosed by the document EP 4 212 897, which is prior art pursuant to Article 54(3) EPO, and by the document US 2002/145406 A1, which discloses a method of diagnosing a failure of a battery pack including an over-current detection circuit, which is checked after assembly through a functional test involving an actual over-current being applied.

### SUMMARY OF THE INVENTION

### Technical Problem

The present invention is to solve the above drawback. An object of the present invention is to provide an overcurrent detection circuit failure diagnostic method and a battery pack which are capable of maintaining an overcurrent detection circuit in a safe state by diagnosing the overcurrent detection circuit.

### Solution To Problem

A method of diagnosing a failure of a battery pack according to an aspect of the present invention is a method of diagnosing a failure of an overcurrent detection circuit of the battery pack as defined in the appended claims. The overcurrent detection circuit is configured to compare, with a threshold value, a detection signal output from a current detection element connected to an output side of a battery unit and to determine an overcurrent when the detection signal indicates an overcurrent value exceeding the threshold value. In this method, a failure of the overcurrent detection circuit is determined by inputting an overcurrent diagnostic signal to the overcurrent detection circuit, wherein said determining the failure of the overcurrent detection circuit comprises determining the failure of the overcurrent detection circuit in an unused state of the battery unit in which the battery unit is not charged or discharged, wherein the method further comprises determining the unused state by detecting, by a microcomputer, an output signal from the current detection element.

A battery pack according to an aspect of the present invention is defined in the appended claims and includes a battery unit, a switching element connected in series with the battery unit, a current detection element connected in series with the battery unit, an overcurrent detection circuit configured to: determine an overcurrent based on an output voltage of the current detection element; and turn off the switching element in an overcurrent state, and a diagnostic circuit configured to diagnose a failure of the overcurrent detection circuit. The diagnostic circuit includes an overcurrent simulation circuit configured to input an overcurrent diagnostic signal to the overcurrent detection circuit. The diagnostic circuit is configured to determine the failure of the overcurrent detection circuit based on the overcurrent diagnostic signal output from the overcurrent simulation circuit to the overcurrent detection circuit, , wherein, while the battery pack is in an unused state in which the battery unit is not charged or discharged, the diagnostic circuit is configured to output the overcurrent diagnostic signal to the overcurrent detection circuit to determine the failure of the overcurrent detection circuit, and wherein the diagnostic circuit includes a microcomputer configured to detect the unused state of the battery pack.

### Advantageous Effect of Invention

The failure diagnostic method and the battery pack described above maintain the battery pack in a safe state by diagnosing whether or not the overcurrent detection circuit operates normally.

### BRIEF DESCRIPTION OF THE DRAWINGS

FIG. 1 is a schematic configuration diagram of a battery pack according to an exemplary embodiment of the present invention.
FIG. 2 is a circuit diagram of a voltage amplifier circuit.
FIG. 3 is a flowchart of diagnosing a failure of an overcurrent detection circuit while the battery pack is not used.

### DESCRIPTION OF EMBODIMENT

A method of diagnosing a failure of a battery pack according to an aspect of the present invention is a method of diagnosing a failure of an overcurrent detection circuit of the battery pack. The overcurrent detection circuit is configured to compare, with a threshold value, a detection signal output from a current detection element connected to an output side of a battery unit and to determine an overcurrent when the detection signal indicates an overcurrent value exceeding the threshold value. In the method, a failure of the overcurrent detection circuit is determined by inputting an overcurrent diagnostic signal to the overcurrent detection circuit.

The above-described method provides an advantageous effect maintaining the battery pack in a safe state by diagnosing whether or the overcurrent detection circuit operates normally with a simple circuit configuration. This is because a failure of the overcurrent detection circuit is diagnosed with a simple circuit configuration in which an overcurrent diagnostic signal is input to the overcurrent detection circuit without causing overcurrent to flow through the battery.

In the method according to the present invention, the failure of the overcurrent detection circuit is determined in an unused state of the battery unit in which the battery unit is not charged or discharged.

In the method described above, the failure of the overcurrent detection circuit is determined in a non-use state in which no power is supplied to the battery unit, so that the failure of the overcurrent detection circuit can be diagnosed accurately.

In the failure diagnostic method of a battery pack according to the present invention, the unused state is determined by detecting, by a microcomputer, an output signal from the current detection element.

In the failure diagnostic method of a battery pack according to another aspect of the present invention, the current detection element is a current detection resistor. The failure of the overcurrent detection circuit is determined by inputting an overcurrent diagnostic voltage to the current detection resistor.

In the failure diagnostic method of a battery pack according to another aspect of the present invention, a comparator compares an output signal of the current detection element with the threshold value. The overcurrent detection circuit determines an overcurrent when the output signal exceeds the threshold value.

The failure diagnostic method described above provides an advantageous effect that a failure of the overcurrent detection circuit is determined in an extremely short period. The overcurrent is promptly detected by the overcurrent detection circuit, and the switching element is instantaneously turned off to cut off the overcurrent. The overcurrent is detected in a short period of time, because, instead of converting the output of the current detection element into a digital signal and performing, the microcomputer performs arithmetic processing to determine overcurrent. The output signal of the current detection element is input to the comparator, and the comparator compares the signal with a threshold value to diagnose overcurrent instantaneously.

In the failure diagnostic method of a battery pack according to another aspect of the present invention, the overcurrent diagnostic signal is a pulse signal of an overcurrent diagnostic voltage having a predetermined pulse width.

The failure diagnostic method described above provides an advantageous effect that the failure is determined in a short period of time by determining the failure of the overcurrent detection circuit with a pulse signal.

In the failure diagnostic method of a battery pack according to another aspect of the present invention, a switching element connected in series with the battery unit is turned off upon detecting the failure of the overcurrent detection circuit.

The failure diagnostic method of a battery pack described above provides an advantageous effect that the switching element connected in series with the battery unit is turned off when the overcurrent detection circuit is determined to have a failure. Hence, the battery pack maintains in a safe state while avoiding continuous use of the battery pack.

A battery pack according to an aspect of the present invention includes a battery unit, a switching element connected in series with the battery unit, a current detection element connected in series with the battery unit, an overcurrent detection circuit configured to: determine an overcurrent based on an output voltage of the current detection element; and turn off the switching element in an overcurrent state, and a diagnostic circuit configured to diagnose a failure of the overcurrent detection circuit. The diagnostic circuit includes an overcurrent simulation circuit configured to input an overcurrent diagnostic signal to the overcurrent detection circuit. The diagnostic circuit is configured to determine the failure of the overcurrent detection circuit based on the overcurrent diagnostic signal output from the overcurrent simulation circuit to the overcurrent detection circuit.

The battery pack described above provides an advantageous effect maintaining in a safe state by diagnosing the overcurrent detection circuit with a simple circuit configuration. This is because it is not necessary to cause overcurrent to flow to diagnose a failure of the overcurrent detection circuit, and the failure of the overcurrent detection circuit is diagnosed with a simple circuit configuration in which the overcurrent simulation circuit inputs an overcurrent diagnostic signal to the overcurrent detection circuit.

In the battery pack according to the present invention, while the battery pack is in an unused state, the diagnostic circuit is configured to output the overcurrent diagnostic signal to the overcurrent detection circuit to determine the failure of the overcurrent detection circuit.

Since the battery pack described above diagnoses the failure of the overcurrent detection circuit in the unused state, the failure of the overcurrent detection circuit is be diagnosed more accurately.

In the battery pack according to the present invention, the diagnostic circuit includes a microcomputer configured to detect the unused state of the battery pack.

In the battery pack according to another aspect of the present invention, the current detection element is a current detection resistor. The overcurrent detection circuit includes a voltage amplifier circuit configured to amplify a voltage of the current detection resistor, and a determination circuit configured to compare an output voltage of the voltage amplifier circuit with a threshold value to determine the overcurrent.

In the battery pack according to another aspect of the present invention, the determination circuit includes a comparator configured to compare the output voltage of the voltage amplifier circuit with the threshold value.

The battery pack described above provides an advantageous effect of diagnosing a failure of the overcurrent detection circuit in real time. Overcurrent is promptly detected, and the switching element is instantaneously turned off to cut off the overcurrent. The overcurrent is detected promptly because, instead of converting the output of the current detection element into a digital signal and performing, by the microcomputer, arithmetic processing to determine overcurrent, the output signal of the current detection element is input to the comparator and the comparator compares the signal with a threshold value to diagnose overcurrent instantaneously.

In the battery pack according to another aspect of the present invention, wherein the overcurrent simulation circuit includes a pulse generation circuit configured to output a pulse signal of an overcurrent diagnostic voltage.

In the battery pack according to another aspect of the present invention, the pulse generation circuit is configured to output the overcurrent diagnostic signal to the overcurrent detection circuit for diagnosis. The overcurrent diagnostic signal has a pulse waveform with a pulse width 0.1 µsec or longer and 1 sec or shorter.

Hereinafter, the present invention will be described in detail with reference to the drawings. It should be noted that in the following description, terms indicating a specific direction or position (for example, "upper", "lower", and other terms including those terms) are used as necessary, but the use of these terms is to facilitate the understanding of the invention with reference to the drawings, and the meaning of these terms does not limit the technical scope of the present invention. In addition, the parts having the same reference numerals appearing in a plurality of drawings indicate the same or equivalent parts or members.

Furthermore, the embodiment described below shows a specific example of the technical idea of the present invention, and does not limit the present invention to the following. In addition, unless otherwise specified, the dimensions, materials, shapes, relative arrangements, and the like of the structural elements described below are not intended to limit the scope of the present invention only thereto, but intended to be exemplified. In addition, the details described in the embodiment or example can be applied to other embodiments or examples. In addition, the size, positional relationship, and the like of the members illustrated in the drawings may be exaggerated in order to clarify the explanation.

### Exemplary Embodiment 1

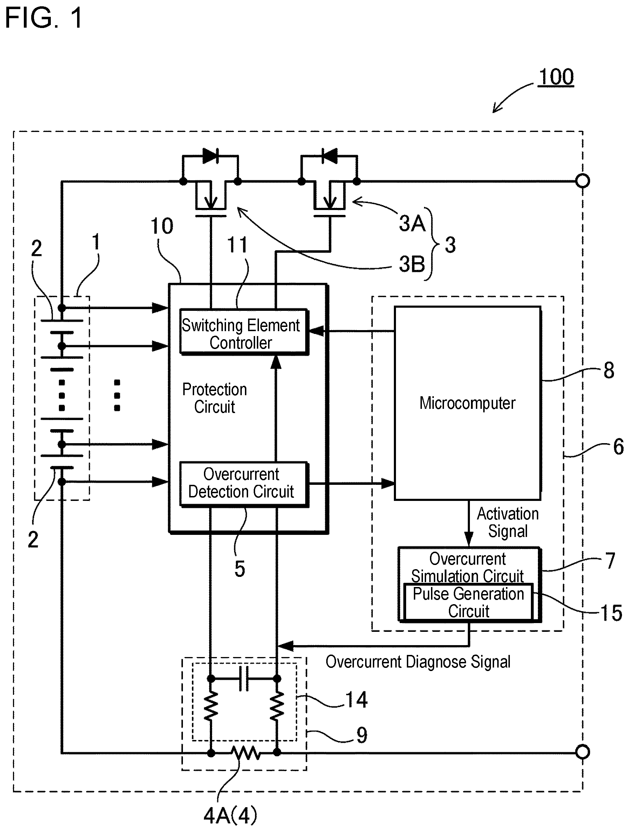

Battery pack 100 illustrated in FIG. 1 includes: battery unit 1 including battery cells 2, switching element 3 connected in series with battery unit 1, current detection element 4 configured to detect current flowing through battery unit 1, protection circuit 10 including overcurrent detection circuit 5 configured to turn on and off switching element 3 in response to a signal from current detection element 4 when overcurrent occurs, and diagnostic circuit 6 configured to diagnose a failure of overcurrent detection circuit 5 of protection circuit 10. Protection circuit 10 includes, in addition to overcurrent detection circuit 5, switching element controller 11 configured to detect overcurrent and control switching element 3. Diagnostic circuit 6 includes microcomputer 8 configured to determine an unused state of battery pack 100 and overcurrent simulation circuit 7 configured to output an overcurrent diagnostic signal to overcurrent detection circuit 5 at the timing of diagnosing the failure of overcurrent detection circuit 5 based on the signal from microcomputer 8.

In battery pack 100 described above, microcomputer 8 determines the unused state of battery pack 100, and overcurrent simulation circuit 7 outputs an overcurrent diagnostic signal to overcurrent detection circuit 5 in response to an activation signal from microcomputer 8, so that a failure of overcurrent detection circuit 5 is determined. Overcurrent simulation circuit 7 outputs an overcurrent diagnostic signal to an input side of overcurrent detection circuit 5 which is an output side of current detection element 4. In battery pack 100, a voltage higher than or equal to the voltage generated when overcurrent flows through current detection element 4 is input to current detection element 4 to create a state where overcurrent flows through current detection element 4, so that a failure of overcurrent detection circuit 5 is determined.

### Battery Unit 1

Battery unit 1 includes battery cells 2 connected in series or in parallel with one another. A non-aqueous electrolyte secondary battery, such as a lithium ion secondary battery having a large charge and discharge capacity, is suitable for each battery cell 2. However, battery cell 2 according to the present invention is not limited to the lithium ion secondary battery, but may be any secondary battery currently available or to be developed in the future, such as a nickel hydride battery or an all-solid-state battery.

### Switching Element 3

A semiconductor switching element, such as a FET or a transistor, may be used as switching element 3, but an FET is preferably used. A FET has features that the on-resistance of the FET is lower than the on-resistance of a transistor, and the power loss in an ON state is small. In battery pack 100 illustrated in FIG. 1, discharging switching element 3A which cuts off discharging current and charging switching element 3B which cuts off charging current are connected in series to each other. A FET is turned on and off based on a gate voltage, and a transistor is turned on and off based on base current.

### Current Detection Element 4

Current detection element 4 may be implemented by current detection resistor 4A connected in series with battery unit 1. A voltage across current detection resistor 4A increases in proportion to current. Since the product of the electrical resistance and the current of current detection resistor 4A is the voltage across current detection resistor 4A, current may be detected based on the voltage across current detection resistor 4A. Since current detection resistor 4A is connected in series with battery unit 1 and consumes power, the electric resistance is determined to be as low as possible to reduce power consumption. Since the voltage induced across current detection resistor 4A with a low electric resistance is low, the voltage is amplified by a differential amplifier, so that current is detected. Instead of current detection resistor 4A, current detection element 4 may be implemented by any other elements configured to output a voltage increasing in proportion to current, such as a current detection element which detects magnetic flux density and which is configured to output an output voltage increases in proportion to current.

### Protection Circuit 10

Protection circuit 10 includes overcurrent detection circuit 5 configured to compare the output signal obtained by amplifying the voltage of current detection element 4 with a threshold value to determine overcurrent, and switching element controller 11 configured to turn on and off switching element 3 in response to a signal from overcurrent detection circuit 5.

### Overcurrent Detection Circuit 5

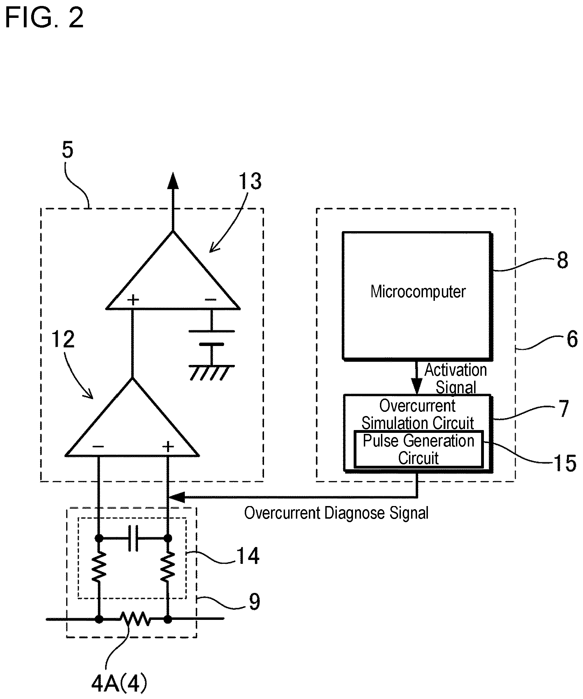

Overcurrent detection circuit 5 includes voltage amplifier circuit 12 configured to amplify the voltage across current detection resistor 4A, and determination circuit 13 configured to compare the output signal of voltage amplifier circuit 12 with the threshold value to determine overcurrent. Since current detection resistor 4A has a low resistance in order to reduce power consumption, the generated voltage is low with respect to flowing current. This is because the generated voltage is proportional to the product of the electrical resistance and the current. Voltage amplifier circuit 12 amplifies the generated low voltage, and outputs the amplified voltage. FIG. 2 illustrates a circuit diagram of voltage amplifier circuit 12 illustrated in FIG. 1. Voltage amplifier circuit 12 illustrated in FIG. 2 is a differential amplifier, and includes inverting and noninverting input terminals connected across current detection resistor 4A. Current detection circuit 9 includes low-pass filter 14 connected between the input terminal and current detection resistor 4A. The resistance value of low-pass filter 14 is determined to be an electric resistance which is sufficiently lower than the input impedance of current detection circuit 9 and is sufficiently higher than the electric resistance of current detection resistor 4A, in order that an overcurrent diagnostic signal from overcurrent simulation circuit 7 to be described later may be input to overcurrent detection circuit 5 without lowering the signal. Current detection circuit 9 with an input terminal connected to low-pass filter 14 is configured to input both the overcurrent diagnostic signal from overcurrent simulation circuit 7 and the generated voltage of current detection resistor 4A to overcurrent detection circuit 5 without lowering the signal and the voltage, and accurately detects the current while accurately diagnosing a failure. In addition, overcurrent simulation circuit 7 may accurately diagnose a failure and accurately detects the current without a circuit which reduces the output impedance.

Determination circuit 13 compares the output signal of voltage amplifier circuit 12 with the threshold value to detect overcurrent. The threshold value determines the lowest current at which overcurrent is determined. FIG. 2 illustrates an exemplary circuit diagram of overcurrent detection circuit 5 illustrated in FIG. 1. As illustrated in FIG. 2, a comparator is preferably used for determination circuit 13. The comparator compares the output voltage of voltage amplifier circuit 12 with a reference voltage determining the threshold value to determine overcurrent. The reference voltage of the comparator is determined to be the output voltage output from current detection circuit 9 while state where the lowest current at which overcurrent is determined flows through current detection resistor 4A. The comparator illustrated in FIG. 2 includes a noninverting input terminal connected to the output of voltage amplifier circuit 12 and an inverting input terminal connected to a positive side of the reference voltage. When the output voltage of voltage amplifier circuit 12 is higher than the reference voltage, that is, when overcurrent flows through current detection resistor 4A, the comparator outputs a High positive signal as an overcurrent detection signal. The overcurrent detection signal is output to microcomputer 8 as a flag.

For failure diagnosis, overcurrent detection circuit 5 operates both while battery pack 100 is in the used state and in the unused state. While battery pack 100 is in the used state, overcurrent flowing through current detection element 4 allows overcurrent detection circuit 5 to output an overcurrent detection signal. While battery pack 100 is in the unused state, when diagnosing a failure of overcurrent detection circuit 5, overcurrent detection circuit 5 outputs an overcurrent detection signal as a flag to microcomputer 8 while overcurrent detection circuit 5 operates normally. Since determination circuit 13 of the comparator compares the output signal of voltage amplifier circuit 12 with the threshold value in real time, determination circuit 13 promptly outputs an overcurrent detection signal when the output signal exceeds the threshold value. Accordingly, while battery pack 100 is in the used state, overcurrent is detected in an extremely short period of time and the current of battery pack 100 is promptly cut off. Moreover, when diagnosing a failure of overcurrent detection circuit 5 while battery pack 100 is in the unused state, failure diagnosis can be performed in a short period of time.

### Switching Element Controller 11

Upon receiving the overcurrent detection signal input from overcurrent detection circuit 5 while battery pack 100 is in the used state, switching element controller 11 switches switching element 3 from turning on to turning off. Battery pack 100 illustrated in FIG. 1 includes discharging switching element 3A and charging switching element 3B which are connected in series to each other. Hence, in response to the overcurrent detection signal, switching element controller 11 turns off discharging switching element 3A, or switches both discharging switching element 3A and charging switching element 3B from turning on to turning off to cut off the overcurrent of battery unit 1. While battery pack 100 is in the used state, switching element controller 11 promptly turns off switching element 3 in response to the overcurrent detection signal output from determination circuit 13 of overcurrent detection circuit 5 without using microcomputer 8. While battery pack 100 is in the unused state, switching element controller 11 turns off switching element 3 in response to an OFF signal input from microcomputer 8. Upon detecting that overcurrent detection circuit 5 does not operate normally, microcomputer 8 causes switching element controller 11 to turn off switching element 3.

### Diagnostic Circuit 6

Diagnostic circuit 6 includes overcurrent simulation circuit 7 configured to input an overcurrent diagnostic signal to overcurrent detection circuit 5 to diagnose a failure of overcurrent detection circuit 5. Overcurrent simulation circuit 7 shown in FIG. 1 and FIG. 2 is connected to current detection element 4 via low-pass filter 14. The resistance value of low-pass filter 14 is set to an electric resistance which is sufficiently higher than the electrical resistance of current detection resistor 4A and sufficiently lower than the input impedance of voltage amplifier circuit 12 provided on the input side of overcurrent detection circuit 5, and is determined to range, for example, from 1 kΩ to 100 kΩ.

Overcurrent simulation circuit 7 is configured to output a pulse signal of an overcurrent diagnostic voltage having a predetermined pulse width as the overcurrent diagnostic signal. Overcurrent simulation circuit 7 illustrated in FIG. 1 and FIG. 2 includes pulse generation circuit 15 configured to output a pulse signal of overcurrent diagnostic voltage. For example, pulse generation circuit 15 outputs an overcurrent diagnostic signal having a pulse waveform with a time width of 0.1 µsec or longer and 1 sec or shorter to the overcurrent detection circuit.

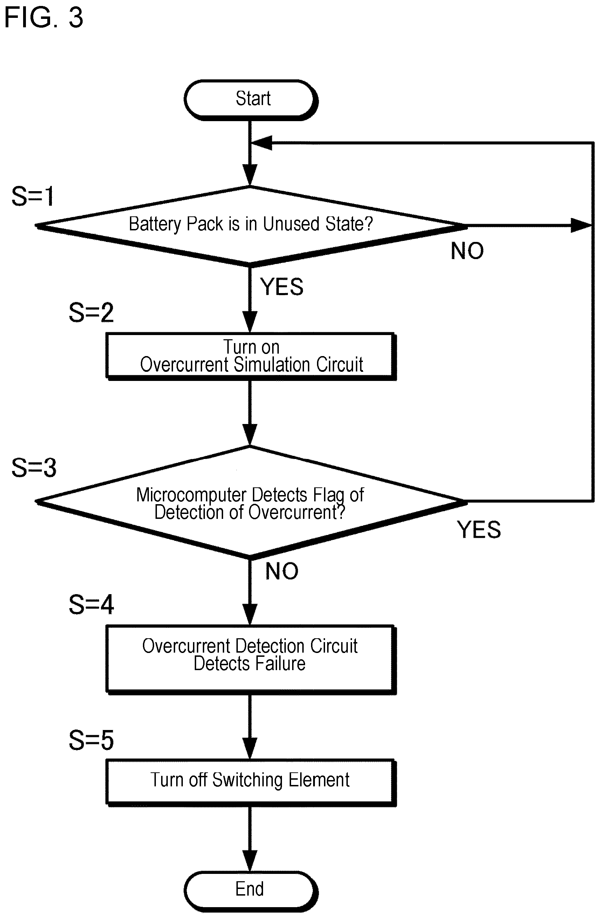

Diagnostic circuit 6 shown in FIG. 1 further includes microcomputer 8. Microcomputer 8 detects the unused state in which battery pack 100 is not used, and diagnoses a failure of overcurrent detection circuit 5. Battery pack 100 in which the unused state is detected and the failure of overcurrent detection circuit 5 is determined is configured to determine the failure of overcurrent detection circuit 5 without affecting the normal used state. For example, microcomputer 8 determines the unused state by detecting that battery unit 1 has not been charged or discharged for a predetermined period of time. Microcomputer 8 diagnoses the failure of overcurrent detection circuit 5 in accordance with the flowchart in FIG. 3 while battery pack 100 is in the unused state. Microcomputer 8 turns on overcurrent simulation circuit 7 in the unused state to diagnose a failure of overcurrent detection circuit 5 in accordance with the following flowchart.

### Step S=1

In this step, microcomputer 8 determines whether battery pack 100 is in the unused state or not. When microcomputer 8 determines that battery pack 100 is in the unused state, the process proceeds to the next step. When battery pack 100 is not in the unused state, this step is repeated.

### Step S=2

When battery pack 100 is in the unused state, overcurrent simulation circuit 7 is turned on in this step, and overcurrent simulation circuit 7 inputs an overcurrent diagnostic signal to overcurrent detection circuit 5. Overcurrent detection circuit 5 to which the overcurrent diagnostic signal has been input outputs an overcurrent detection signal and outputs a flag to microcomputer 8 when overcurrent detection circuit 5 is in a normal operating state. Overcurrent detection circuit 5 in the normal operating state outputs the overcurrent detection signal in response to the overcurrent diagnostic signal. However, overcurrent detection circuit 5 which is not in a normal operating state does not output the overcurrent detection signal as a flag in response to the overcurrent diagnostic signal. Hence, microcomputer 8 determines whether overcurrent detection circuit 5 is in the normal operating state or has a failure by detection of the flag of the overcurrent detection signal.

### Steps S=3 to S=5

When overcurrent detection circuit 5 is in the normal operating state and microcomputer 8 detects the flag from overcurrent detection circuit 5, the process jumps to step S=1, and executes the loop of S=1 to S=3, and the failure diagnosis of overcurrent detection circuit 5 is repeated in Step S=2. When overcurrent detection circuit 5 is not in the normal operating state, microcomputer 8 cannot detect the flag. The process then proceeds to the next step S=4, and microcomputer 8 determines that overcurrent detection circuit 5 has a failure. When overcurrent detection circuit 5 is determined to have a failure, the process proceeds to step S=5, and microcomputer 8 turns off switching element 3 to cut off the current of battery unit 1.

While battery pack 100 of the battery is in the used state, switching element 3 is turned off in response to the overcurrent detection signal output from determination circuit 13 of overcurrent detection circuit 5. While battery pack 100 is in the unused state, microcomputer 8 detects that overcurrent detection circuit 5 does not output the overcurrent detection signal, and switching element controller 11 turns off switching element 3. This is because while battery pack 100 is in the used state, it is necessary to turn off switching element 3 in response to the overcurrent detection signal to cut off the overcurrent at the timing when charging and discharging current flows through battery unit 1. But while battery pack 100 is in the unused state, at the timing of diagnosing a failure of overcurrent detection circuit 5, overcurrent detection circuit 5 is determined to have a failure in a state where the overcurrent detection signal is not output, and the current of battery unit 1 is cut off.

### INDUSTRIAL APPLICABILITY

The present invention relates to a battery pack which includes an overcurrent detection circuit, and which can be used for various purposes. The battery pack can be used safely and securely by diagnosing a failure of the overcurrent detection circuit.

### REFERENCE MARKS IN THE DRAWINGS

- 100: battery pack
- 1: battery unit
- 2: battery cell
- 3: switching element
- 3A: discharging switching element
- 3B: charging switching element
- 4: current detection element
- 4A: current detection resistor
- 5: overcurrent detection circuit
- 6: diagnostic circuit
- 7: overcurrent simulation circuit
- 8: microcomputer
- 9: current detection circuit
- 10: protection circuit
- 11: switching element controller
- 12: voltage amplifier circuit
- 13: determination circuit
- 14: low-pass filter
- 15: pulse generation circuit

## Claims

1. A method of diagnosing a failure of a battery pack (100) including an overcurrent detection circuit (5), the overcurrent detection circuit (5) being configured to compare, with a threshold value, a detection signal output from a current detection element (4) connected to an output side of a battery unit (1) and to determine an overcurrent when the detection signal indicates an overcurrent value exceeding the threshold value, the method comprising:
determining a failure of the overcurrent detection circuit (5) by inputting an overcurrent diagnostic signal to the overcurrent detection circuit (5), wherein said determining the failure of the overcurrent detection circuit (5) comprises determining the failure of the overcurrent detection circuit (5) in an unused state of the battery unit (1) in which the battery unit (1) is not charged or discharged,
wherein the method further comprises
determining the unused state by detecting, by a microcomputer (8), an output signal from the current detection element (4).

2. The method of claim 1, wherein
the current detection element (4) is a current detection resistor (4A), and
said determining the failure of the overcurrent detection circuit (5) comprising determining the failure of the overcurrent detection circuit (5) by inputting an overcurrent diagnostic voltage to the current detection resistor (4A).

3. The method of claim 1 or 2, further comprising
comparing, by a comparator, an output signal of the current detection element (4) with the threshold value; and
determining, by the overcurrent detection circuit (5), an overcurrent when the output signal exceeds the threshold value.

4. The method of any one of claims 1 to 3, wherein the overcurrent diagnostic signal is a pulse signal of an overcurrent diagnostic voltage having a predetermined pulse width.

5. The method of any one of claims 1 to 4, further comprising
turning off a switching element (3) connected in series with the battery unit (1) upon detecting the failure of the overcurrent detection circuit (5).

6. A battery pack (100) comprising:
a battery unit (1);
a switching element (3) connected in series with the battery unit (1);
a current detection element (4) connected in series with the battery unit (1);
an overcurrent detection circuit (5) configured to
determine an overcurrent based on an output voltage of the current detection element (4), and
turn off the switching element (3) in an overcurrent state; and
a diagnostic circuit (6) configured to diagnose a failure of the overcurrent detection circuit (5), wherein
the diagnostic circuit (6) includes an overcurrent simulation circuit (7) configured to input an overcurrent diagnostic signal to the overcurrent detection circuit (5),
the diagnostic circuit (6) is configured to determine the failure of the overcurrent detection circuit (5) based on the overcurrent diagnostic signal output from the overcurrent simulation circuit (7) to the overcurrent detection circuit (5),
wherein, while the battery pack (100) is in an unused state in which the battery unit (1) is not charged or discharged, the diagnostic circuit (6) is configured to output the overcurrent diagnostic signal to the overcurrent detection circuit (5) to determine the failure of the overcurrent detection circuit (5), and
wherein the diagnostic circuit (6) includes a microcomputer (8) configured to detect the unused state of the battery pack (100).

7. The battery pack (100) of claim 6, wherein
the current detection element (4) is a current detection resistor (4A), and
the overcurrent detection circuit (5) includes:
a voltage amplifier circuit (12) configured to amplify a voltage of the current detection resistor (4A); and
a determination circuit (13) configured to compare an output voltage of the voltage amplifier circuit (12) with a threshold value to determine the overcurrent.

8. The battery pack (100) of claim 7, wherein the determination circuit (13) includes a comparator configured to compare the output voltage of the voltage amplifier circuit (12) with the threshold value.

9. The battery pack (100) of any one of claims 6 to 8, wherein the overcurrent simulation circuit (7) includes a pulse generation circuit (15) configured to output a pulse signal of an overcurrent diagnostic voltage.

10. The battery pack (100) of claim 9, wherein the pulse generation circuit (15) is configured to output the overcurrent diagnostic signal to the overcurrent detection circuit (5) for diagnosis, the overcurrent diagnostic signal having a pulse waveform with a pulse width 0.1 µsec or longer and 1 sec or shorter.

11. A method of diagnosing a failure of a battery pack (100) including an overcurrent detection circuit (5), the overcurrent detection circuit (5) being configured to compare, with a threshold value, a detection signal output from a current detection element (4) connected to an output side of a battery unit (1) and to determine an overcurrent when the detection signal indicates an overcurrent value exceeding the threshold value, the method comprising:
determining a failure of the overcurrent detection circuit (5) by inputting an overcurrent diagnostic signal to the overcurrent detection circuit (5), wherein
the overcurrent diagnostic signal is a pulse signal of an overcurrent diagnostic voltage having a predetermined pulse width.

12. A battery pack (100) comprising:
a battery unit (1);
a switching element (3) connected in series with the battery unit (1);
a current detection element (4) connected in series with the battery unit (1);
an overcurrent detection circuit (5) configured to
determine an overcurrent based on an output voltage of the current detection element (4), and
turn off the switching element (3) in an overcurrent state; and
a diagnostic circuit (6) configured to diagnose a failure of the overcurrent detection circuit (5), wherein
the diagnostic circuit (6) includes an overcurrent simulation circuit (7) configured to input an overcurrent diagnostic signal to the overcurrent detection circuit (5),
the diagnostic circuit (6) is configured to determine the failure of the overcurrent detection circuit (5) based on the overcurrent diagnostic signal output from the overcurrent simulation circuit (7) to the overcurrent detection circuit (5),
wherein
the overcurrent simulation circuit (7) includes a pulse generation circuit (15) configured to output a pulse signal of an overcurrent diagnostic voltage having a predetermined pulse width as the overcurrent diagnostic signal.

## Patentansprüche

1. Verfahren zum Diagnostizieren eines Fehlers eines Batteriepacks (100), das eine Überstromerkennungsschaltung (5) umfasst, wobei die Überstromerkennungsschaltung (5) ausgebildet ist, um ein Erfassungssignal, das von einem mit einer Ausgangsseite einer Batterieeinheit (1) verbundenen Stromerfassungselement (4) ausgegeben wird, mit einem Schwellenwert zu vergleichen und einen Überstrom zu bestimmen, wenn das Erfassungssignal einen den Schwellenwert überschreitenden Überstromwert angibt, wobei das Verfahren umfasst:
Bestimmen eines Fehlers der Überstromerkennungsschaltung (5) durch Eingeben eines Überstrom-Diagnosesignals in die Überstromerkennungsschaltung (5), wobei das Bestimmen des Fehlers der Überstromerkennungsschaltung (5) ein Bestimmen des Fehlers der Überstromerkennungsschaltung (5) in einem unbenutzten Zustand der Batterieeinheit (1), in dem die Batterieeinheit (1) weder geladen noch entladen wird, umfasst,
wobei das Verfahren ferner umfasst
Bestimmen des unbenutzten Zustands durch Erfassen, durch einen Mikrocomputer (8), eines Ausgangssignals von dem Stromerfassungselement (4).

2. Verfahren nach Anspruch 1, wobei
das Stromerfassungselement (4) ein Stromerfassungswiderstand (4A) ist, und
das Bestimmen des Fehlers der Überstromerkennungsschaltung (5) ein Bestimmen des Fehlers der Überstromerkennungsschaltung (5) durch Eingeben einer Überstrom-Diagnosespannung in den Stromerfassungswiderstand (4A) umfassend.

3. Verfahren nach Anspruch 1 oder 2, ferner umfassend
Vergleichen, durch einen Komparator, eines Ausgangssignals des Stromerfassungselements (4) mit dem Schwellenwert; und
Bestimmen, durch die Überstromerkennungsschaltung (5), eines Überstroms, wenn das Ausgangssignal den Schwellenwert überschreitet.

4. Verfahren nach einem der Ansprüche 1 bis 3, wobei das Überstrom-Diagnosesignal ein Impulssignal einer Überstrom-Diagnosespannung mit einer vorbestimmten Impulsbreite ist.

5. Verfahren nach einem der Ansprüche 1 bis 4, ferner umfassend
Ausschalten eines Schaltelements (3), das in Reihe mit der Batterieeinheit (1) geschaltet ist, bei Erfassung des Fehlers der Überstromerkennungsschaltung (5).

6. Batteriepack (100), umfassend:
eine Batterieeinheit (1);
ein Schaltelement (3), das in Reihe mit der Batterieeinheit (1) geschaltet ist;
ein Stromerfassungselement (4), das in Reihe mit der Batterieeinheit (1) geschaltet ist;
eine Überstromerkennungsschaltung (5), die ausgebildet ist, um
einen Überstrom auf der Grundlage einer Ausgangsspannung des Stromerfassungselements (4) zu bestimmen, und
das Schaltelement (3) in einem Überstromzustand auszuschalten; und
eine Diagnoseschaltung (6), die ausgebildet ist, um einen Fehler der Überstromerkennungsschaltung (5) zu diagnostizieren, wobei die Diagnoseschaltung (6) eine Überstromsimulationsschaltung (7) umfasst, die ausgebildet ist, um ein Überstrom-Diagnosesignal in die Überstromerkennungsschaltung (5) einzugeben,
die Diagnoseschaltung (6) ausgebildet ist, um den Fehler der Überstromerkennungsschaltung (5) auf der Grundlage des von der Überstromsimulationsschaltung (7) an die Überstromerkennungsschaltung (5) ausgegebenen Überstrom-Diagnosesignals zu bestimmen,
wobei, während sich das Batteriepack (100) in einem unbenutzten Zustand befindet, in dem die Batterieeinheit (1) weder geladen noch entladen wird, die Diagnoseschaltung (6) ausgebildet ist, um das Überstrom-Diagnosesignal an die Überstromerkennungsschaltung (5) auszugeben, um den Fehler der Überstromerkennungsschaltung (5) zu bestimmen, und
wobei die Diagnoseschaltung (6) einen Mikrocomputer (8) umfasst, der ausgebildet ist, um den unbenutzten Zustand des Batteriepacks (100) zu erfassen.

7. Batteriepack (100) nach Anspruch 6, wobei
das Stromerfassungselement (4) ein Stromerfassungswiderstand (4A) ist, und die Überstromerkennungsschaltung (5) umfasst:
eine Spannungsverstärkerschaltung (12), die ausgebildet ist, um eine Spannung des Stromerfassungswiderstands (4A) zu verstärken; und
eine Bestimmungsschaltung (13), die ausgebildet ist, um eine Ausgangsspannung der Spannungsverstärkerschaltung (12) mit einem Schwellenwert zu vergleichen, um den Überstrom zu bestimmen.

8. Batteriepack (100) nach Anspruch 7, wobei die Bestimmungsschaltung (13) einen Komparator umfasst, der ausgebildet ist, um die Ausgangsspannung der Spannungsverstärkerschaltung (12) mit dem Schwellenwert zu vergleichen.

9. Batteriepack (100) nach einem der Ansprüche 6 bis 8, wobei die Überstromsimulationsschaltung (7) eine Impulserzeugungsschaltung (15) umfasst, die ausgebildet ist, um ein Impulssignal einer Überstrom-Diagnosespannung auszugeben.

10. Batteriepack (100) nach Anspruch 9, wobei die Impulserzeugungsschaltung (15) ausgebildet ist, um das Überstrom-Diagnosesignal zur Diagnose an die Überstromerkennungsschaltung (5) auszugeben, wobei das Überstrom-Diagnosesignal eine Impulswellenform mit einer Impulsbreite von 0,1 µsec oder länger und 1 sec oder kürzer aufweist.

11. Verfahren zum Diagnostizieren eines Fehlers eines Batteriepacks (100), das eine Überstromerkennungsschaltung (5) umfasst, wobei die Überstromerkennungsschaltung (5) ausgebildet ist, um ein Erfassungssignal, das von einem mit einer Ausgangsseite einer Batterieeinheit (1) verbundenen Stromerfassungselement (4) ausgegeben wird, mit einem Schwellenwert zu vergleichen und einen Überstrom zu bestimmen, wenn das Erfassungssignal einen den Schwellenwert überschreitenden Überstromwert angibt, wobei das Verfahren umfasst:
Bestimmen eines Fehlers der Überstromerkennungsschaltung (5) durch Eingeben eines Überstrom-Diagnosesignals in die Überstromerkennungsschaltung (5), wobei
das Überstrom-Diagnosesignal ein Impulssignal einer Überstrom-Diagnosespannung mit einer vorbestimmten Impulsbreite ist.

12. Batteriepack (100), umfassend:
eine Batterieeinheit (1);
ein Schaltelement (3), das in Reihe mit der Batterieeinheit (1) geschaltet ist;
ein Stromerfassungselement (4), das in Reihe mit der Batterieeinheit (1) geschaltet ist;
eine Überstromerkennungsschaltung (5), die ausgebildet ist, um
einen Überstrom auf der Grundlage einer Ausgangsspannung des Stromerfassungselements (4) zu bestimmen, und
das Schaltelement (3) in einem Überstromzustand auszuschalten; und
eine Diagnoseschaltung (6), die ausgebildet ist, um einen Fehler der Überstromerkennungsschaltung (5) zu diagnostizieren, wobei
die Diagnoseschaltung (6) eine Überstromsimulationsschaltung (7) umfasst, die ausgebildet ist, um ein Überstrom-Diagnosesignal in die Überstromerkennungsschaltung (5) einzugeben,
die Diagnoseschaltung (6) ausgebildet ist, um den Fehler der Überstromerkennungsschaltung (5) auf der Grundlage des von der Überstromsimulationsschaltung (7) an die Überstromerkennungsschaltung (5) ausgegebenen Überstrom-Diagnosesignals zu bestimmen,
wobei
die Überstromsimulationsschaltung (7) eine Impulserzeugungsschaltung (15) umfasst,
die ausgebildet ist, um als das Überstrom-Diagnosesignal ein Impulssignal einer Überstrom-Diagnosespannung mit einer vorbestimmten Impulsbreite auszugeben.

## Revendications

1. Procédé de diagnostic d'une défaillance d'un bloc-batterie (100) comprenant un circuit de détection de surintensité (5), le circuit de détection de surintensité (5) étant configuré pour comparer, à une valeur seuil, un signal de détection délivré par un élément de détection de courant (4) connecté à un côté de sortie d'une unité de batterie (1) et pour déterminer une surintensité lorsque le signal de détection indique une valeur de surintensité dépassant la valeur seuil, le procédé comprenant :
la détermination d'une défaillance du circuit de détection de surintensité (5) en introduisant un signal de diagnostic de surintensité dans le circuit de détection de surintensité (5), dans lequel ladite détermination de la défaillance du circuit de détection de surintensité (5) comprend la détermination de la défaillance du circuit de détection de surintensité (5) dans un état inutilisé de l'unité de batterie (1) dans lequel l'unité de batterie (1) n'est ni chargée ni déchargée,
dans lequel le procédé comprend en outre
la détermination de l'état inutilisé en détectant, par un micro-ordinateur (8), un signal de sortie provenant de l'élément de détection de courant (4).

2. Procédé selon la revendication 1, dans lequel
l'élément de détection de courant (4) est une résistance de détection de courant (4A), et ladite détermination de la défaillance du circuit de détection de surintensité (5) comprenant la détermination de la défaillance du circuit de détection de surintensité (5) en introduisant une tension de diagnostic de surintensité dans la résistance de détection de courant (4A).

3. Procédé selon la revendication 1 ou 2, comprenant en outre
la comparaison, par un comparateur, d'un signal de sortie de l'élément de détection de courant (4) avec la valeur seuil ; et
la détermination, par le circuit de détection de surintensité (5), d'une surintensité lorsque le signal de sortie dépasse la valeur seuil.

4. Procédé selon l'une quelconque des revendications 1 à 3, dans lequel le signal de diagnostic de surintensité est un signal impulsionnel d'une tension de diagnostic de surintensité ayant une largeur d'impulsion prédéterminée.

5. Procédé selon l'une quelconque des revendications 1 à 4, comprenant en outre la désactivation d'un élément de commutation (3) connecté en série avec l'unité de batterie (1) lors de la détection de la défaillance du circuit de détection de surintensité (5).

6. Bloc-batterie (100) comprenant :
une unité de batterie (1) ;
un élément de commutation (3) connecté en série avec l'unité de batterie (1) ;
un élément de détection de courant (4) connecté en série avec l'unité de batterie (1) ;
un circuit de détection de surintensité (5) configuré pour
déterminer une surintensité sur la base d'une tension de sortie de l'élément de détection de courant (4), et
désactiver l'élément de commutation (3) dans un état de surintensité ; et
un circuit de diagnostic (6) configuré pour diagnostiquer une défaillance du circuit de détection de surintensité (5), dans lequel
le circuit de diagnostic (6) comprend un circuit de simulation de surintensité (7) configuré pour introduire un signal de diagnostic de surintensité dans le circuit de détection de surintensité (5),
le circuit de diagnostic (6) est configuré pour déterminer la défaillance du circuit de détection de surintensité (5) sur la base du signal de diagnostic de surintensité délivré par le circuit de simulation de surintensité (7) au circuit de détection de surintensité (5), dans lequel, tandis que le bloc-batterie (100) est dans un état inutilisé dans lequel l'unité de batterie (1) n'est ni chargée ni déchargée, le circuit de diagnostic (6) est configuré pour délivrer le signal de diagnostic de surintensité au circuit de détection de surintensité (5) pour déterminer la défaillance du circuit de détection de surintensité (5), et
dans lequel le circuit de diagnostic (6) comprend un micro-ordinateur (8) configuré pour détecter l'état inutilisé du bloc-batterie (100).

7. Bloc-batterie (100) selon la revendication 6, dans lequel
l'élément de détection de courant (4) est une résistance de détection de courant (4A), et le circuit de détection de surintensité (5) comprend :
un circuit amplificateur de tension (12) configuré pour amplifier une tension de la résistance de détection de courant (4A) ; et
un circuit de détermination (13) configuré pour comparer une tension de sortie du circuit amplificateur de tension (12) avec une valeur seuil pour déterminer la surintensité.

8. Bloc-batterie (100) selon la revendication 7, dans lequel le circuit de détermination (13) comprend un comparateur configuré pour comparer la tension de sortie du circuit amplificateur de tension (12) avec la valeur seuil.

9. Bloc-batterie (100) selon l'une quelconque des revendications 6 à 8, dans lequel le circuit de simulation de surintensité (7) comprend un circuit de génération d'impulsions (15) configuré pour délivrer un signal impulsionnel d'une tension de diagnostic de surintensité.

10. Bloc-batterie (100) selon la revendication 9, dans lequel le circuit de génération d'impulsions (15) est configuré pour délivrer le signal de diagnostic de surintensité au circuit de détection de surintensité (5) pour le diagnostic, le signal de diagnostic de surintensité ayant une forme d'onde impulsionnelle avec une largeur d'impulsion de 0,1 µsec ou plus et de 1 sec ou moins.

11. Procédé de diagnostic d'une défaillance d'un bloc-batterie (100) comprenant un circuit de détection de surintensité (5), le circuit de détection de surintensité (5) étant configuré pour comparer, à une valeur seuil, un signal de détection délivré par un élément de détection de courant (4) connecté à un côté de sortie d'une unité de batterie (1) et pour déterminer une surintensité lorsque le signal de détection indique une valeur de surintensité dépassant la valeur seuil, le procédé comprenant :
la détermination d'une défaillance du circuit de détection de surintensité (5) en introduisant un signal de diagnostic de surintensité dans le circuit de détection de surintensité (5), dans lequel
le signal de diagnostic de surintensité est un signal impulsionnel d'une tension de diagnostic de surintensité ayant une largeur d'impulsion prédéterminée.

12. Bloc-batterie (100) comprenant :
une unité de batterie (1) ;
un élément de commutation (3) connecté en série avec l'unité de batterie (1) ;
un élément de détection de courant (4) connecté en série avec l'unité de batterie (1) ;
un circuit de détection de surintensité (5) configuré pour
déterminer une surintensité sur la base d'une tension de sortie de l'élément de détection de courant (4), et
désactiver l'élément de commutation (3) dans un état de surintensité ; et
un circuit de diagnostic (6) configuré pour diagnostiquer une défaillance du circuit de détection de surintensité (5), dans lequel
le circuit de diagnostic (6) comprend un circuit de simulation de surintensité (7) configuré pour introduire un signal de diagnostic de surintensité dans le circuit de détection de surintensité (5),
le circuit de diagnostic (6) est configuré pour déterminer la défaillance du circuit de détection de surintensité (5) sur la base du signal de diagnostic de surintensité délivré par le circuit de simulation de surintensité (7) au circuit de détection de surintensité (5), dans lequel
le circuit de simulation de surintensité (7) comprend un circuit de génération d'impulsions (15) configuré pour délivrer un signal impulsionnel d'une tension de diagnostic de surintensité ayant une largeur d'impulsion prédéterminée en tant que signal de diagnostic de surintensité.
